(19) Europäisches Patentamt

European Patent Office

Office européen des brevets

(11) Numéro de publication : **0 066 515**
**B1**

(12) # FASCICULE DE BREVET EUROPÉEN

(45) Date de publication du fascicule du brevet :
21.11.85

(51) Int. Cl.⁴ : **G 01 H   3/00, H 04 R  29/00**

(21) Numéro de dépôt : **82400973.2**

(22) Date de dépôt : **26.05.82**

(54) Appareil générateur de bruit et dispositif de contrôle de l'isolement phonique dans des bâtiments.

(30) Priorité : 27.05.81 FR 8110620

(43) Date de publication de la demande :
08.12.82 Bulletin 82/49

(45) Mention de la délivrance du brevet :
21.11.85 Bulletin 85/47

(84) Etats contractants désignés :
AT BE CH DE GB IT LI LU NL SE

(56) Documents cités :
DE-A- 2 620 327
FR-A- 2 413 009
FR-A- 2 479 524
US-A- 3 732 370
J. AUDIO ENGINEERING SOCIETY, vol. 26, no. 3,
1978, pages 120-129, New York (USA); W.R. BEVAN:
"A simplified equalization analyzer"
Arrêtés du Ministère de l'Equipement de la République Française, datés du 14 juin 1979 et du 10 février
1972

(73) Titulaire : ETAT FRANÇAIS représenté par Le Ministère de l'Urbanisme et du Logement Laboratoire
Central des Ponts et Chaussées
58 boulevard Lefebvre
F-75732 Paris Cedex 15 (FR)

(72) Inventeur : Cannard, Georges
Les Ifs La Chenaie
F-69350 La Mulatiere (FR)
Inventeur : Charlet, Pierre
30 rue de Montribloud
F-69160 Tassin La Demi Lune (FR)
Inventeur : Gorand, Jean-Luc
13 rue Gérard Philippe
F-69500 Bron (FR)

(74) Mandataire : Thevenet, Jean-Bruno et al
Cabinet BEAU DE LOMENIE 55 rue d'Amsterdam
F-75008 Paris (FR)

**0 066 515**

## Description

La présente invention concerne un appareil générateur de bruit et dispositif de contrôle de l'isolement phonique dans des bâtiments, comprenant un ensemble d'émission de bruit placé dans une même pièce d'habitation constitué par un générateur de bruit, un haut-parleur relié au générateur de bruit et un microphone de contrôle.

Lors de la construction de bâtiments, notamment de logements d'habitation, il est nécessaire d'effectuer des mesures d'isolement phonique entre logements voisins afin de contrôler la conformité au règlement de construction.

Pour mesurer le coefficient d'isolation à l'intérieur de locaux d'habitations, il est normalement prévu d'installer dans une pièce, dite émettrice, un haut-parleur de diffusion d'un bruit blanc compris dans une gamme de fréquences prédéterminées par exemple 125 à 4 000 hertz, et de mesurer ce bruit émis par l'intermédiaire d'un microphone de contrôle installé dans la même pièce. Cette installation est complétée par des moyens d'enregistrement disposés dans une pièce réceptrice contiguë à la pièce émettrice.

Il s'avère que, compte tenu des caractéristiques de réverbération des pièces, le bruit émis n'est jamais réellement conforme à la norme prescrite et connaît notamment une atténuation des basses et hautes fréquences. Les mesures effectuées sont donc souvent inexploitables en pratique dans la mesure où elles ne peuvent pas être comprises dans le cadre fourni par la réglementation devant être appliquée.

On connaît par le document de brevet FR-A-2 413 009 un système de correction de la courbe de réponse d'une chaîne électro-acoustique, lequel système de correction est ajouté aux autres éléments de la chaîne et peut être mis sélectivement en service pour permettre alors, pendant la durée de cette mise en service, une adaptation automatique de la chaîne à l'environnement. Une fois cette adaptation réalisée, le système de correction est déconnecté jusqu'à une prochaine utilisation visant à réaliser une nouvelle adaptation à un nouvel environnement. Ce système implique donc d'agir manuellement pour déclencher une adaptation des caractéristiques de la chaîne à des modifications de l'environnement ce qui conduit à une interruption de l'utilisation de la chaîne. Pendant cette opération d'adaptation, le préamplificateur est déconnecté pour être remplacé par un générateur de bruit rose.

Le système décrit dans le document précité ne concerne d'ailleurs pas directement un appareil générateur de bruit susceptible de garantir automatiquement la production d'un bruit de caractéristiques prédéterminées quelles que soient les caractéristiques particulières de l'environnement.

La présente invention a précisément pour objet de remédier aux inconvénients précités et à permettre une simplification des mesures d'isolement phonique entre logements pour les contrôles de conformité au règlement de la construction tout en diminuant le prix de revient et en garantissant des mesures qui entrent véritablement dans le cadre des normes imposées quelles que soient les caractéristiques de réverbération des pièces dans lesquelles s'effectuent les mesures de contrôle et notamment quels que soient la forme et l'ameublement du local.

Ces buts sont atteints grâce à un appareil générateur de bruit du type défini en tête de la description qui, conformément à l'invention, comprend une première série de n filtres d'octave pour filtrer par bande d'octave le bruit généré par le générateur de bruit, une deuxième série de n filtres d'octave identiques aux filtres de la première série de filtres pour filtrer par bande d'octave le bruit capté par le microphone de contrôle, une série de n circuits de détermination de valeur efficace connectés respectivement à chacune des sorties des n filtres de la deuxième série de filtres d'octave, une série de n circuits assurant la production de niveaux de bruit de référence pour chacune des bandes d'octave du bruit à générer, une série de n comparateurs attribués chacun respectivement à un filtre de la deuxième série de filtres et présentant une première entrée connectée au circuit de détermination de valeur efficace du filtre correspondant et une deuxième entrée connectée au circuit assurant la production de niveau de bruit de référence du filtre correspondant, une série de n amplificateurs associés respectivement aux n comparateurs, une série de n circuits multiplieurs présentant chacun une première entrée connectée à la sortie de l'amplificateur associé à un filtre de la deuxième série de filtres et une deuxième entrée connectée à la sortie du filtre correspondant de la première série de filtres, un circuit sommateur connecté aux sorties des n circuits multiplieurs et un amplificateur de puissance pour appliquer au haut-parleur le signal de sortie de l'amplificateur de puissance. Dans ce qui précède et dans l'ensemble de la description, n représente un nombre entier.

Le haut-parleur d'émission est ainsi asservi par le microphone de contrôle de sorte que ce dernier peut piloter le fonctionnement du haut-parleur en fonction d'un programme de référence et peut ainsi garantir la production d'un bruit de spectre et de niveau déterminés dans un local d'habitation quelles que soient les caractéristiques particulières de réverbération. Le haut-parleur d'émission et le microphone de contrôle étant asservis en boucle dans la pièce d'émission, le bruit émis peut ainsi être ajusté en fonction des caractéristiques particulières telles que la forme et l'ameublement du local qui conditionnent les caractéristiques de réverbération.

Avantageusement, le générateur de bruit est un générateur de bruit blanc. L'appareil selon l'invention peut encore comprendre un dispositif d'affichage du niveau de bruit reçu par le microphone de contrôle, par bande d'octave.

Ce dispositif d'affichage du niveau de bruit par bande d'octave peut comprendre n circuits convertisseurs valeur efficace-logarithme connectés respectivement aux n circuits de détermination de

2

valeur efficace et n circuits de commande d'affichage de diodes électroluminescentes connectés respectivement aux n circuits convertisseurs.

L'invention concerne également un dispositif de contrôle de l'isolement phonique dans des bâtiments comportant un appareil générateur de bruit comprenant un ensemble d'émission de bruit placé dans une même pièce d'habitation constitué par un générateur de bruit, un haut-parleur relié au générateur de bruit et un microphone de contrôle, destiné à être placé dans une première pièce, et des moyens destinés à être placés dans une seconde pièce, contiguë à la première pièce, pour assurer l'enregistrement du bruit perçu à partir du bruit émis par le haut-parleur dudit appareil générateur de bruit situé dans la première pièce, caractérisé en ce que l'appareil générateur est constitué par l'appareil générateur défini ci-dessus.

D'autres caractéristiques et avantages de l'invention ressortiront de la description qui fait suite d'un mode particulier de réalisation de l'invention, en référence au dessin annexé, sur lequel :

la figure 1 est un schéma de principe de l'appareil générateur de bruit selon l'invention,

la figure 2 montre un exemple de réalisation plus particulier de l'appareil selon la figure 1.

la figure 3 présente le schéma d'un générateur de bruit blanc utilisable dans le cadre de l'invention, et

la figure 4 montre le schéma de filtres utilisables dans le cadre de l'invention.

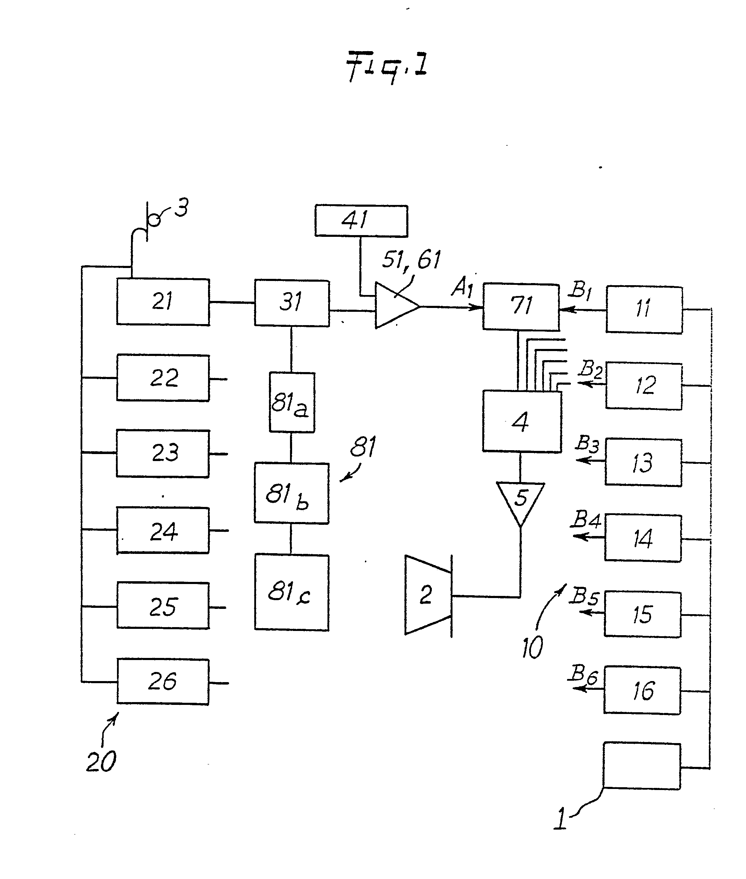

On voit sur la figure 1 un schéma bloc donnant le principe d'un appareil générateur de bruit destiné à être placé dans un local dit d'émission et à produire dans ce local un bruit stable et constant de caractéristiques prédéterminées, quels que soient la forme et l'ameublement de ce local, et sans qu'il soit nécessaire d'avoir recours à des réglages extérieurs.

Un dispositif de détection, non représenté sur la figure 1, comprenant un microphone de mesure et des moyens d'enregistrement des signaux délivrés par ce microphone, est placé dans une pièce contiguë au local dans lequel est installé l'appareil générateur de bruit selon l'invention. Ce dispositif de détection permet d'effectuer des mesures d'isolement phonique entre le local contenant l'appareil générateur de bruit et le local contenant le dispositif de détection, par comparaison entre les caractéristiques des signaux captés et enregistrés par le dispositif de détection et les caractéristiques connues et stables du bruit émis par l'appareil générateur de bruit. Le résultat des mesures peut être significatif et servir à des contrôles de conformité dans la mesure où le bruit émis par le générateur de bruit reste bien compris dans les normes imposées. La mise en œuvre d'une boucle d'asservissement pour l'appareil générateur de bruit permet précisément de garantir un maintien automatique des caractéristiques du bruit émis à l'intérieur de normes prédéterminées indépendamment des caractéristiques particulières du local d'émission. L'appareil générateur de bruit selon l'invention peut donc être réutilisé dans des locaux différents sans qu'il soit nécessaire à chaque fois de modifier les caractéristiques de cet appareil.

L'appareil selon l'invention comprend essentiellement un générateur de bruit blanc 1 délivrant un bruit blanc pseudo-aléatoire de période relativement courte, par exemple de l'ordre de 1 à 3 secondes. Ce bruit blanc est ensuite filtré par bande d'octave à l'aide d'une série 10 de six filtres 11 à 16. Ces filtres d'octave 11 à 16 permettent ainsi selon un exemple typique de répartir le bruit blanc compris entre 125 et 4 000 Hz selon six bandes d'octave $B_1$ à $B_6$.

Les signaux $B_1$ à $B_6$, après passage dans un circuit de régulation qui va être décrit ci-après, sont ensuite additionnés dans un circuit sommateur 4, puis amplifiés dans un amplificateur de puissance 5 pour être émis par un haut-parleur 2. Le bruit émis par le haut-parleur 2 présente des caractéristiques définies à la construction qui dépendent notamment du générateur de bruit blanc 1 et de l'amplificateur 5. En l'absence de circuit de régulation, le bruit perçu par un microphone de contrôle 3 serait toutefois dépendant des caractéristiques extérieures du local, et on observait notamment une atténuation du bruit émis qui serait réalisée de façon irrégulière en fonction des fréquences. L'invention remédie à cet inconvénient en utilisant le microphone de contrôle 3 non seulement pour permettre un affichage des caractéristiques du bruit émis par le haut-parleur 2, tel que perçu dans le local d'émission, mais encore pour réguler l'amplification sélective par bande d'octave du bruit à émettre de manière à maintenir pour chaque bande d'octave des niveaux d'émission conformes à des caractéristiques prédéterminées.

Le niveau de bruit capté par le microphone de contrôle 3, placé dans un endroit conventionnel du local d'émission, est filtré par bande d'octaves à l'aide d'une deuxième série 20 de six filtres d'octave 21 à 26 qui correspondent respectivement aux six filtres d'octave 11 à 16 associés au générateur de bruit blanc 1. Chaque signal de sortie d'un filtre de la deuxième série 20 de filtre sert à réguler l'amplification du signal de sortie du filtre correspondant de la première série 10 de filtres avant application de celui-ci au circuit sommateur 4.

On a représenté sur la figure 1 une seule boucle de régulation 31, 41, 51, 61, 71 qui est associée aux premiers filtres 11 et 21 des première et seconde séries de filtres 10, 20 et va être maintenant décrite. Naturellement, des boucles de régulation similaires sont associées à chacune des autres paires de filtres 12, 22 ; ... 16, 26 des première et seconde séries de filtres 10, 20.

La sortie du filtre d'octave 21 associé au microphone de contrôle 3 est appliquée à un circuit 31 de détermination de valeur efficace destiné à fournir la valeur efficace du niveau de bruit perçu par le microphone 3 pour cette bande d'octave. Un circuit 41 assure la production d'un niveau de référence prédéterminé qui correspond au niveau de bruit souhaité pour la bande d'octave considérée en fonction du spectre de bruit qui doit être généré. Les signaux fournis par le circuit 31 de détermination de valeur efficace et par le circuit 41 d'élaboration d'un niveau de référence sont appliqués sur les deux entrées d'un circuit comparateur 51 qui produit en sortie un signal différence $\varepsilon_1$ entre le niveau de bruit reçu et le niveau de référence fixé pour la bande d'octave considérée. Ce signal différence $\varepsilon_1$ est amplifié dans un amplificateur 61 dont le gain G est le plus grand possible tout en restant compatible avec une bonne stabilité de la boucle d'asservissement. La valeur $A_1$ du signal produit en sortie du circuit amplificateur 61 sert de commande de gain variable par bande d'octave et modifie la valeur du signal $B_1$ fourni par le filtre d'octave correspondant 11 de la première série de filtres 10. Les signaux $A_1$ et $B_1$ issus respectivement de l'amplificateur 61 et du filtre 11 sont appliqués à deux entrées d'un circuit multiplieur 71 et c'est la sortie du circuit multiplieur 71 qui est appliquée au circuit sommateur 4. Toutes les sorties des amplificateurs à gain variable constitués par les circuits multiplieurs tels que 71 associés aux différentes boucles de régulation associées aux différents couples de filtres 11, 21 ; ... 16, 26 sont ainsi appliquées au circuit sommateur 4 pour recomposer en sortie un bruit dont le spectre correspond à celui fixé au départ à l'aide des différents circuits d'élaboration de niveau de référence tels que 41. Le bruit électronique fourni par le circuit sommateur 4 est amplifié par l'étage de puissance 5 avant d'être transformé en vibrations sonores par le haut-parleur 2.

Le système décrit ci-dessus est avantageusement complété par un ensemble d'affichage du niveau de bruit reçu au niveau du microphone de contrôle, par bande d'octave. Cet ensemble d'affichage comprend une série de six étages tels que 81 associés respectivement à chacun des filtres 21 à 26 de la deuxième série de filtres 20 connectée au microphone de contrôle 3. Chaque étage tel que 81 comprend un circuit de conversion de valeur efficace-logarithme tel que 81a connecté à la sortie du circuit de détermination de valeur efficace correspondant, tel que 31, un circuit de commande d'affichage tel que 81b et des moyens tels que 81c d'affichage du niveau de bruit reçu par le microphone 3 par bande d'octave, constitués par exemple par une barrette de diodes électroluminescentes. On peut ainsi disposer de par exemple une barrette de seize diodes par bande d'octave représentant des niveaux compris entre 85 et 100 dB par bonds de 1 dB. L'ensemble des différentes barrettes permet de visualiser le spectre du bruit émis. Le circuit de commande d'affichage tel que 81b peut être un circuit classique à une entrée et sorties multiples, le rang de la sortie activée étant fonction de la tension d'entrée.

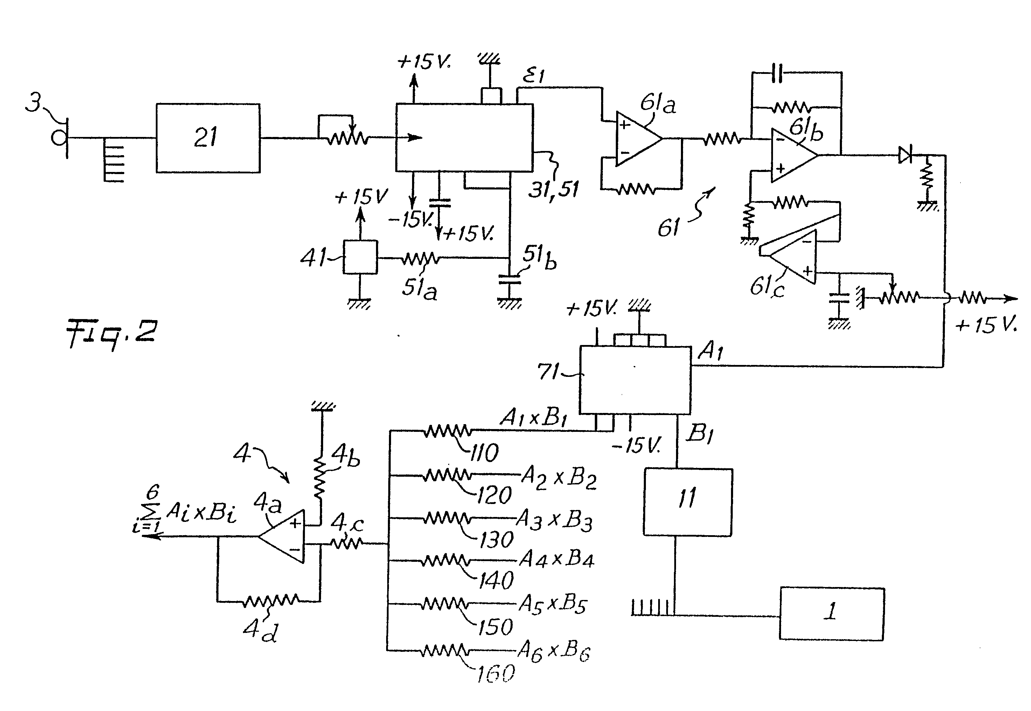

La figure 2 représente un mode particulier de réalisation d'une boucle d'asservissement utilisable en combinaison avec un couple de filtres d'octave associés tels que les filtres 11, 21.

Dans le cas de ce mode de réalisation de la figure 2, un même circuit intégré 31, 51 permet de réaliser la conversion du signal alternatif fourni par le filtre d'octave 21 connecté au microphone 3 en un signal représentant la valeur efficace de ce signal alternatif, tout en effectuant simultanément la comparaison de ce signal de valeur efficace avec un niveau de référence élaboré par le circuit 41 et appliqué au circuit convertisseur et comparateur 31, 51 par l'intermédiaire d'un filtre passe-bas comprenant la résistance 51a et le condensateur 51b. Pour chaque bande d'octave, un circuit tel que 41 permet de fixer un niveau d'émission déterminé, par exemple de l'ordre de 95 dB/octave. Il est également possible de prévoir la fixation d'un niveau de bruit croissant par bande d'octave (par exemple croissant de + 3 dB/octave) afin de tenir compte des variations d'isolement des parois à contrôler en fonction de la fréquence. Ce réglage peut être effectué une fois pour toutes en fonction de la réglementation à appliquer et donc du type de signal de bruit à générer pour réaliser des contrôles d'isolement phonique. Les boucles d'asservissement décrites permettent ensuite de garantir la production d'un bruit conforme aux caractéristiques déterminées par les différents niveaux de référence choisis.

Le signal $\varepsilon_1$ fourni en sortie du circuit 31, 51 correspond à la différence entre la valeur efficace du signal alternatif fourni par le filtre 21 et le niveau de référence prédéterminé affiché par le circuit 41. Le signal $\varepsilon_1$ est ensuite amplifié par un amplificateur 61 comprenant trois amplificateurs opérationnels 61a, 61b, 61c et présentant un gain G. Le signal de sortie $A_1$ de l'amplificateur 61 que constitue le produit G. $\varepsilon_1$ est alors combiné au signal de sortie $B_1$ du filtre d'octave 11 correspondant à la boucle d'asservissement concernée, dans un circuit multiplieur 71 dont la dynamique est importante.

La figure 2 montre un circuit additionneur 4 comprenant un amplificateur opérationnel 4a monté en circuit sommateur avec des résistances 4b, 4c, 4d et six résistances 110, 120, 130, 140, 150, 160 qui permettent l'application des signaux $A_1$ $B_1$, $A_2$ $B_2$, ... $A_6$ $B_6$ issus respectivement des diverses boucles de régulation associées aux filtres 11, 21 ; 12, 22 ; ... 16, 26. Le signal de sortie du circuit additionneur 4 constitue un signal de bruit recomposé qui peut alors être appliqué de façon classique à un haut-parleur 2 par l'intermédiaire d'un amplificateur de puissance 5 qui sert également d'adaptateur d'impédance pour le haut-parleur. On notera que les caractéristiques particulières du haut-parleur 2 n'interviennent pas dans les mesures du fait que le bruit émis est toujours contrôlé par le microphone 3 qui permet lui-même d'agir sur la production du bruit désiré.

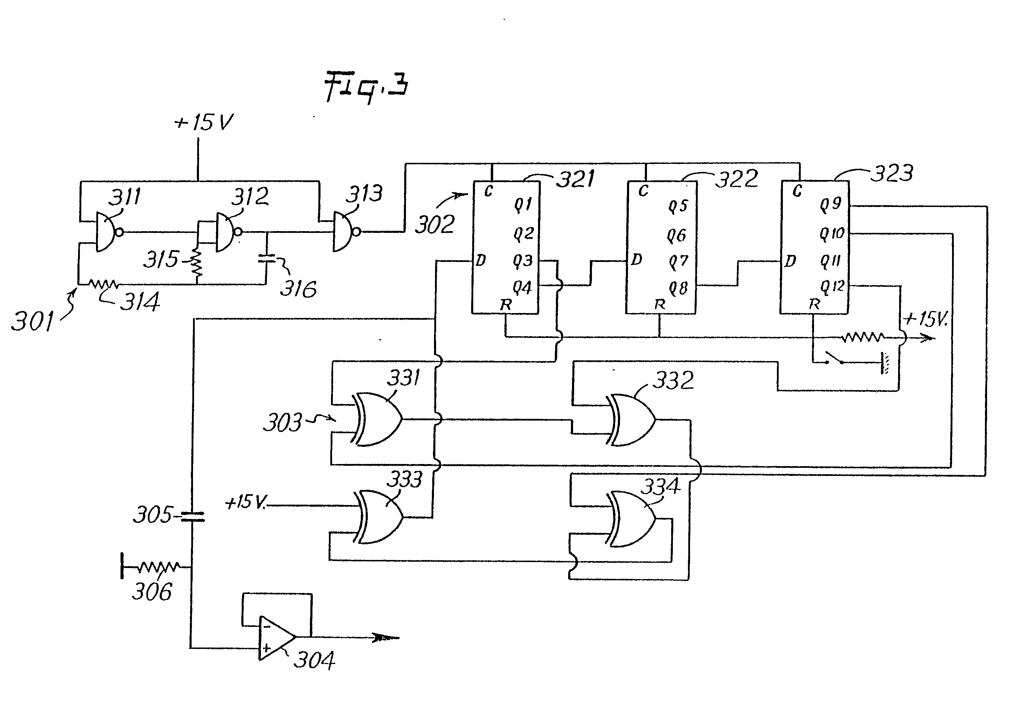

La figure 3 montre un exemple de réalisation de générateur de bruit blanc utilisable dans l'appareil selon l'invention. Ce générateur pseudo-aléatoire repose sur le principe selon lequel certaines séquences binaires, cycliques possèdent la propriété de répartition, au hasard, de leurs 0 et 1. Ces séquences sont générées par un registre à décalage 302 bouclé sur un additionneur exclusif 303. Le registre à décalage 302 comprend trois étages 321, 322, 323, et l'additionneur exclusif 303 est constitué à partir de quatre portes OU exclusif 331 à 334. Le registre à décalage 302 est commandé par une horloge 301 qui peut être réalisée de façon classique à partir de trois portes NON ET 311, 312, 313 montées en boucle instable avec des résistances 314, 315 et un condensateur 316. Le bruit généré en sortie du registre à décalage 302 peut

4

alors être appliqué, par l'intermédiaire d'un filtre passe-haut composé d'un condensateur 305 et d'une résistance 306, et d'un amplificateur opérationnel 304 monté en étage suiveur, à la première série 10 de filtres 11 à 16 de la figure 1.

La puissance du bruit obtenue en sortie du générateur 1 est constante dans une plage allant de 0 à 0,45 F où F est la fréquence d'horloge. Compte tenu de la plage de fréquences utile pour des contrôles d'isolement phonique (0 à 6 000 Hz), la fréquence d'horloge F peut avantageusement être choisie de l'ordre de 15 kHz. La fréquence de récurrence du générateur pseudoaléatoire doit être la plus basse possible. Si n est le nombre de décades disponibles dans le registre à décalage 302 et si $M = 2n - 1$, la fréquence de récurrence $Fr = F/M$. Si $n = 12$ et $F = 15$ kHz, la fréquence de récurrence $F_r$ est alors égale à 4 Hz, ce qui est tout à fait satisfaisant.

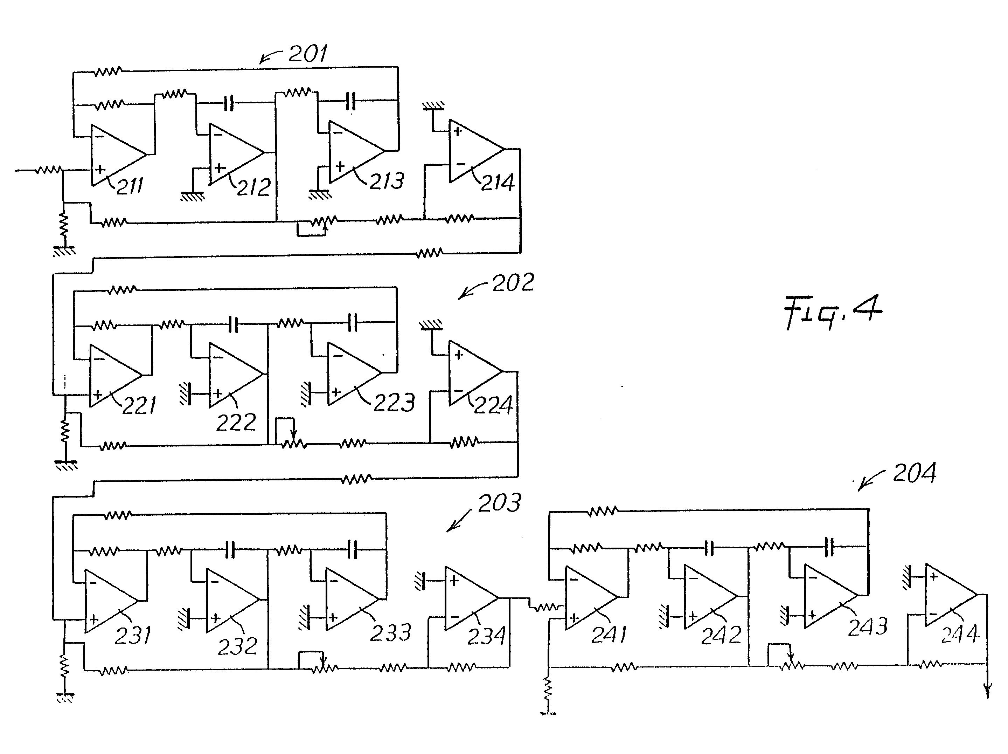

La figure 4 montre un exemple de schéma applicable pour réaliser ces différents filtres d'octave 11 à 16 et 21 à 16. Le filtre passe-bande de la figure 4 est du type Tchebyscheff et comprend quatre étages 201, 202, 203, 204 montés en cascade constituant chacun un filtre actif du second ordre réalisé à partir de réseaux actifs RC et quatre amplificateurs opérationnels 211 à 214, 221 à 224, 231 à 234 et 241 à 244 respectivement. La configuration de filtre retenue permet de limiter le nombre de condensateurs par rapport au nombre de résistances (deux condensateurs par étage) et donc de faciliter la réalisation dans la mesure où des résistances de précision sont plus facilement disponibles que des condensateurs de précision. Les valeurs des composants sont déterminées en fonction des caractéristiques souhaitées pour les filtres. Un gabarit de filtres utilisé à titre d'exemple est le suivant :

$\Delta \geqslant 18$ dB pour $f = 0,5$ fm et $f = 2$ fm
$\Delta \geqslant 40$ dB pour $f = 0,25$ fm et $f = 4$ fm
$\Delta \geqslant 60$ dB pour $f = 0,125$ fm et $f = 8$ fm

$\Delta$ étant l'atténuation en dehors de la bande et fm la fréquence centrale du filtre.

Ces données impliquent la présence de quatre étages pour un filtre du type Tchebyscheff.

Une bande passante à 3 dB et une largeur d'une octave impliquent pour la configuration retenue $Q = 1,567$. A partir de cette valeur, les fréquences propres $f_n$ des différents étages du filtre et les coefficients de surtension $Q_n$ de ces étages sont les suivants :

| Etage | fn | Qn |
|-------|---------|---------|
| 1 | 1,14468 | 3,73544 |
| 2 | 0,87361 | 3,73536 |
| 3 | 1,37613 | 9,39630 |
| 4 | 0,72667 | 9,39580 |

Bien entendu, diverses modifications et adjonctions peuvent être apportées par l'homme de l'art aux modes de réalisation décrits. Ainsi, le nombre n de filtres d'octave de chaque série de filtres 10 et 20 peut être différent de six et être égal par exemple à cinq ou sept en fonction des applications envisagées.

## Revendications

1. Appareil générateur de bruit pour le contrôle de l'isolement phonique dans des bâtiments, comprenant un ensemble d'émission de bruit placé dans une même pièce d'habitation constitué par un générateur de bruit (1), un haut-parleur (2) relié au générateur de bruit (1) et un microphone de contrôle (3), caractérisé en ce qu'il comprend une première série de n filtres d'octave (11 à 16) pour filtrer par bande d'octave le bruit généré par le générateur de bruit (1), une deuxième série de n filtres d'octave (21 à 26) identiques aux filtres de la première série de filtres (11 à 16) pour filtrer par bande d'octave le bruit capté par le microphone de contrôle (3), une série de n circuits de détermination de valeur efficace (31) connectés respectivement à chacune des sorties des n filtres de la deuxième série de filtres d'octave (21 à 26), une série de n circuits (41) assurant la production de niveaux de bruit de référence pour chacune des bandes d'octave du bruit à générer, une série de n comparateurs (51) attribués chacun respectivement à un filtre de la deuxième série de filtres (21 à 26) et présentant une première entrée connectée au circuit de détermination de valeur efficace (31) du filtre correspondant (21) et une deuxième entrée connectée au circuit assurant la production de niveau de bruit de référence (41) du filtre correspondant (21), une série de n amplificateurs (61) associés respectivement aux n comparateurs (51), une série de n circuits multiplieurs (71) présentant chacun une première entrée connectée à la sortie de l'amplificateur (61) associé à un filtre (21) de la deuxième série de filtres (21 à 26) et une deuxième entrée connectée à la sortie du filtre correspondant (11) de la première série de filtres (11 à 16) ; un circuit sommateur (4) connecté aux sorties des n circuits multiplieurs (71) et un amplificateur de puissance (5) pour appliquer au haut-parleur (2) le signal de sortie de l'amplificateur de puissance (5).

2. Appareil selon la revendication 1, caractérisé en ce que le générateur de bruit (1) est un générateur de bruit blanc.

3. Appareil selon la revendication 1 ou 2, caractérisé en ce qu'il comprend en outre un dispositif (81) d'affichage du niveau de bruit reçu par le microphone de contrôle (3), par bande d'octave.

4. Appareil selon la revendication 3, caractérisé en ce que le dispositif (81) d'affichage du niveau de bruit par bande d'octave comprend n circuits convertisseurs valeur efficace-logarithme (81a) connectés respectivement aux n circuits de détermination de valeur efficace (31) et n circuits (81b) de commande d'affichage de diodes électroluminescentes (81c) connectés respectivement aux n circuits convertisseurs (81a).

5. Appareil selon l'une quelconque des revendications 1 à 4, caractérisé en ce que la première et la deuxième séries de filtres (11 à 16 ; 21 à 26) comprennent chacune six filtres d'octave.

6. Appareil selon l'une quelconque des revendications 1 à 5, caractérisé en ce que les filtres des première et deuxième séries de filtres (11 à 16 ; 21 à 26) sont du type Tchebyscheff.

7. Appareil selon la revendication 2 ou l'une quelconque des revendications 3 à 6 combinées à la revendication 2, caractérisé en ce que le générateur de bruit blanc (1) émet un bruit blanc aléatoire de faible période de récurrence inférieure à quelques secondes.

8. Dispositif de contrôle de l'isolement phonique dans des bâtiments comportant un appareil générateur de bruit comprenant un ensemble d'émission de bruit placé dans une même pièce d'habitation constitué par un générateur de bruit (1), un haut-parleur (2) relié au générateur de bruit (1) et un microphone de contrôle (3), destiné à être placé dans une première pièce, et des moyens destinés à être placés dans une seconde pièce, contiguë à la première pièce, pour assurer l'enregistrement du bruit perçu à partir du bruit émis par le haut-parleur (2) dudit appareil générateur de bruit situé dans la première pièce, caractérisé en ce que l'appareil générateur est constitué par l'appareil générateur défini dans l'une quelconque des revendications 1 à 7.

**Claims**

1. Sound-generating apparatus for controlling the phonic insulation in buildings, comprising a sound-issuing assembly placed in the same dwelling room constituted by a sound-generating means (1), a loud-speaker (2) connected to the sound-generating means (1), and a control microphone (3), characterized in that it comprises a first series of n octave filters (11 to 16) for filtering by octave bands the sound generated by the sound-generating means (1), a second series of n octave filters (21 to 26) identical to the filters of the first series of filters (11 to 16) for filtering by octave bands the sound recorded by the control microphone (3), a series of n networks for determining an effective value (31) respectively connected to each of the outputs of the n filters of the second series of octave filters (21 to 26), a series of n circuits (41) ensuring the production of levels of reference sound for each of the octave bands of the sound to be generated, a series of n comparators (51) each allotted respectively to a filter of the second series of filters (21 to 26) and having a first input connected to the network for determining an effective value (31) of the corresponding filter (21) and a second input connected to the network for producing the level of sound reference (41) of the corresponding filter (21), a series of n amplifiers (61) respectively associated to n comparators (51), a series of n multiplying networks (71) each having a first input connected to the output of the amplifier (61) associated to a filter (21) of the second series of filters (21 to 26) and a second input connected to the output of the corresponding filter (11) of the first series of filters (11 to 16), a summing network (4) connected to the outputs of n multiplying networks (71) and a power amplifier (5) to apply to the loud speaker (2) the output signal of the power amplifier (5).

2. Apparatus according to claim 1, characterized in that the sound-generating device (1) is a device generating random sound.

3. Apparatus according to claim 1 or 2, characterized in that it further comprises a device (81) for displaying the level of the sound recorded by the control microphone (3), by octave band.

4. Apparatus according to claim 3, characterized in that the device (81) displaying the sound level by octave band comprises n converter networks of effective-value-logarithm (81a) respectively connected to n network for determining the effective value (31) and n networks (81b) for controlling the display of electroluminescent diodes (81c) respectively connected to n converting networks (81a).

5. Apparatus according to any one of claims 1 to 4, characterized in that the first and second series of filters (11 to 16 ; 21 to 26) each comprise six octave filters.

6. Apparatus according to any one of claims 1 to 5, characterized in that the filters of the first and second series of filters (11 to 16 ; 21 to 26) are of the Tchebyscheff type.

7. Apparatus according to claim 2, or any one of claims 3 to 6 combined to claim 2, characterized in that the random sound generating device delivers a random variable sound of low sequence time, less than a few seconds.

8. Device for controlling the phonic insulation in buildings comprising a sound-generating apparatus comprising a sound-delivering assembly placed in the same dwelling room, constituted by a sound-generating means (1), a loud speaker (2) connected to the sound-generating means (1) and a control microphone (3) intended to be placed in a first room, and means intended to be placed in a second room, contiguous to the first room, to ensure the recording of the sound heard, and delivered by the loud speaker (2) of said sound-generating apparatus situated in the first room, characterized in that the generating apparatus is constituted by the generating apparatus defined in any one of claims 1 to 7.

**Patentansprüche**

1. Geräuscherzeugender Apparat zur Kontrolle der Schallisolierung in Gebäuden, mit einer in einem Wohnraum angeordneten Geräuschemissionsgruppe, bestehend aus einem Geräuscherzeuger (1), einem an den Geräuscherzeuger angeschlossenen Lautsprecher (2) und einem Kontrollmikrofon (3), dadurch gekennzeichnet, daß er eine erste Serie von n Oktavenfiltern (11 bis 16) zum Filtern des vom Geräuscherzeuger (1) erzeugten Geräusches mittels Oktavenband, eine zweite Serie von n Oktavenfiltern (21 bis 26), die identisch zu den Filtern der ersten Serie von Filtern (11 bis 16) ist, zum Filtern des vom Kontrollmikrofon (3) aufgenommenen Geräusches mittels Oktavenband, eine Serie von n Kreisen (31) zur Bestimmung des Effektivwerts, die jeweils an einen Ausgang der n Filter der zweiten Serie von Oktavenfiltern (21 bis 26) angeschlossen sind, eine Serie von n Kreisen (41) zur Gewährleistung der Erzeugung von Referenzgeräuschpegeln für jedes der Oktavenbänder des zu erzeugenden Geräusches, eine Serie von n Komparatoren (51), die jeweils einem Filter der zweiten Serie von Filtern (21 bis 26) zugeordnet sind und einen ersten, an den Effektivwertbestimmungskreis (31) des entsprechenden Filters (21) angeschlossenen Eingang und eine zweiten, an den Kreis (41) zur Gewährleistung der Erzeugung von Referenzgeräuschpegeln des entsprechenden Filters (21) angeschlossenen Eingang, eine Serie von jeweils mit den n Komparatoren (51) verbundenen Verstärkern (61), eine Serie von n Multiplikatorkreisen (71) mit jeweils einem ersten Eingang, der an den Ausgang des mit einem Filter (21) der zweiten Serie von Filtern (21 bis 26) verbundenen Verstärkers (61) angeschlossen ist, und einem zweiten Eingang, der an den Ausgang des entsprechenden Filters (11) der ersten Serie von Filtern (11 bis 16) angeschlossen ist, einen an die Ausgänge der n Multiplikatorkreise (71) angeschlossenen Summierkreis (4) und einen Leistungsverstärker (5) zum Anlegen des Ausgangssignals des Leistungsverstärkers (5) an den Lautsprecher (2) umfaßt.

2. Apparat nach Anspruch 1, dadurch gekennzeichnet, daß der Geräuscherzeuger (1) ein Erzeuger von weißem Rauschen ist.

3. Apparat nach Anspruch 1 oder 2, dadurch gekennzeichnet, daß er weiters eine Vorrichtung (81) zur Anzeige des vom Kontrollmikrofon (3) empfangenen Geräuschpegels mittels Oktavenband umfaßt.

4. Apparat nach Anspruch 3, dadurch gekennzeichnet, daß die Vorrichtung (81) zur Anzeige des Geräuschpegels mittels Oktavenband n Effektivwert-Logarithmus-Umsetzkreise (81a) umfaßt, die jeweils an die n Effektivwertbestimmungskreise (31) angeschlossen sind, und n Anzeigesteuerkreise (81b) mit elektrolumineszierenden Dioden (81c) umfaßt, die jeweils an die n Umsetzkreise (81a) angeschlossen sind.

5. Apparat nach einem der Ansprüche 1 bis 4, dadurch gekennzeichnet, daß die erste und die zweite Serie von Filtern (11 bis 16 ; 21 bis 26) jeweils sechs Oktavenfilter aufweisen.

6. Apparat nach einem der Ansprüche 1 bis 5, dadurch gekennzeichnet, daß die Filter der ersten und zweiten Serie von Filtern (11 bis 16 ; 21 bis 26) Filter des Tchebyscheff-Typs sind.

7. Apparat nach Anspruch 2 oder einem der Ansprüche 3 bis 6 in Kombination mit Anspruch 2, dadurch gekennzeichnet, daß der Erzeuger von weißem Rauschen (1) ein zufälliges weißes Rauschen von geringer Wiederholungsfolge, die niedriger als einige Sekunden ist, abgibt.

8. Vorrichtung zur Kontrolle der Schallisolierung in Gebäuden, umfassend einen geräuscherzeugenden Apparat mit einer in einem Wohnraum angeordneten Geräuschemissionsgruppe, bestehend aus einem Geräuscherzeuger (1), einem an den Geräuscherzeuger (1) angeschlossenen Lautsprecher (2) und einem Kontrollmikrofon (3), zum Aufstellen in einem ersten Raum, und Mittel zum Aufstellen in einem zweiten, an den ersten Raum angrenzenden Raum zur Gewährleistung der Aufzeichnung des wahrgenommenen Geräusches, ausgehend von dem vom Lautsprecher (2) des im ersten Raum befindlichen geräuscherzeugenden Apparats entsendeten Geräusch, dadurch gekennzeichnet, daß der geräuscherzeugende Apparat durch einen Apparat nach einem der Ansprüche 1 bis 7 gebildet ist.

Fig.1

Fig. 2

0 066 515

Fig.3

Fig.4

0 066 515